# EUROPEAN PATENT SPECIFICATION

(11) **EP 2 911 210 B1**
(45) Date of publication and mention of the grant of the patent: **11.03.2020**
(21) Application number: 15155810.3
(22) Date of filing: 19.02.2015
(51) Int. Cl.: H01L 35/30, F01N 5/02

(54) **Electricity generator with low environmental impact, for a vehicle run on fuel**
Elektrischer Generator mit geringer Auswirkung auf die Umwelt für ein kraftstoffbetriebenes Fahrzeug
Générateur d'électricité à faible impact sur l'environnement pour un véhicule à essence

(30) Priority: 24.02.2014 IT MI20140269
(43) Date of publication of application: 26.08.2015
(73) Proprietor: Mobil Tech Srl, 20813 Bovisio-Masciago (MB) (IT)
(72) Inventor: Barin, Luca, 20814 Varedo (MB) (IT)
(74) Representative: Modiano, Micaela Nadia

(56) References cited:
- US-A1- 2006 066 106
- US-A1- 2011 240 080
- US-A1- 2013 079 981
- US-A1- 2014 020 730

## Description

The present invention relates to an electricity generator for a vehicle run on fuel, as well as a vehicle provided with such electricity generator.

Currently several different types of current generators are known which can be used on means of transport such as, in particular, camper vans and vehicles fitted out for use by a stallholder, but also on automobiles, both for charging the batteries of the vehicle, and for supplying any onboard user devices or electrical devices present in the vehicle, in particular when the vehicle is stationary and the engine of the vehicle is switched off.

The most widespread current generators are constituted by heat engines powered by gas, gasoline or Diesel fuel, which actuate an alternator that produces current. These current generators make it possible to obtain relatively high power levels; however, they suffer the problem of excessive noise. Furthermore these systems suffer from the drawback of necessitating frequent maintenance and of generating, in addition to exhaust fumes, residues that are particularly damaging to the environment, such as for example exhausted oil.

Current generators are further known which use fuel cells powered with methanol, hydrogen, or with the fuel known by the name hydronite. Although such generators are sufficiently silent, they have extremely high purchase costs and running costs, owing for example to the necessity of sourcing the fuel and storing it correctly and safely. Furthermore their operation is very heavily influenced by low ambient temperatures.

Currently the use is also known of solar panel systems as electricity generators for vehicles. These systems have a minimal environmental impact, given that they work with sunlight alone and they do not necessitate any kind of fuel. However, such systems can provide only low levels of electric power and only in conditions of strong solar radiation. As a consequence their use is greatly limited.

US 2011/240080 discloses a method of controlling the temperature of a thermoelectric generator (TEG) in an exhaust system of an engine. The method includes determining the temperature of the heated side of the TEG, determining exhaust gas flow rate through the TEG, and determining the exhaust gas temperature through the TEG. A rate of change in temperature of the heated side of the TEG is predicted based on the determined temperature, the determined exhaust gas flow rate, and the determined exhaust gas temperature through the TEG. Using the predicted rate of change of temperature of the heated side, exhaust gas flow rate through the TEG is calculated that will result in a maximum temperature of the heated side of the TEG less than a predetermined critical temperature given the predicted rate of change in temperature of the heated side of the TEG. A corresponding apparatus is provided.

US 2013/079981 discloses implementing an optimized waste heat recovery system, comprising calculating a temperature and a rate of change in temperature of a heat exchanger of a waste heat recovery system, and predicting a temperature and a rate of change in temperature of a material flowing through a channel of the waste heat recovery system. Upon determining the rate of change in the temperature of the material is predicted to be higher than the rate of change in the temperature of the heat exchanger, the optimized waste heat recovery system calculates a valve position and timing for the channel that is configurable for achieving a rate of material flow that is determined to produce and maintain a defined threshold temperature of the heat exchanger, and actuates the valve according to the calculated valve position and calculated timing.

US2006/0066106 discloses an auxiliary electrical power generator for a vehicle. The generator has a vehicular fuel delivery system with a bulk fuel tank for storing liquid fuel and a fuel pump for providing pressurized liquid fuel to an internal combustion engine. A thermoelectric generator is close-coupled to a fuel combustor and converts the heat from fuel combustion into electrical power. A combustor fuel delivery system supplies the liquid fuel to the combustor for combustion.

The aim of the present invention consists in providing an electricity generator for a vehicle run on fuel which compensates for the drawbacks and overcomes the limitations of the known art.

Within this aim, an object of the present invention is to provide an electricity generator that has a minimal environmental and acoustic impact.

Another object of the invention consists in providing an electricity generator that has no moving parts and therefore does not necessitate frequent maintenance.

Another object of the invention consists in providing an electricity generator that can operate under any environmental conditions.

Another object of the invention consists in providing an electricity generator that does not require a special and expensive type of fuel in order to operate.

Another object of the invention consists in providing an electricity generator for which there are no difficulties in sourcing and storing the fuel to run it.

Another object of the invention consists in providing an electricity generator that is capable of offering the widest guarantees of reliability and safety in use, and which is easy to provide and economically competitive when compared to the known art.

In accordance with the invention, there is provided an electricity generator for a vehicle as defined in the appended claims.

Further characteristics and advantages of the invention will become better apparent from the detailed description of a preferred, but not exclusive, embodiment of an electricity generator for a vehicle run on fuel, which is illustrated by way of non-limiting example in the accompanying drawings wherein:

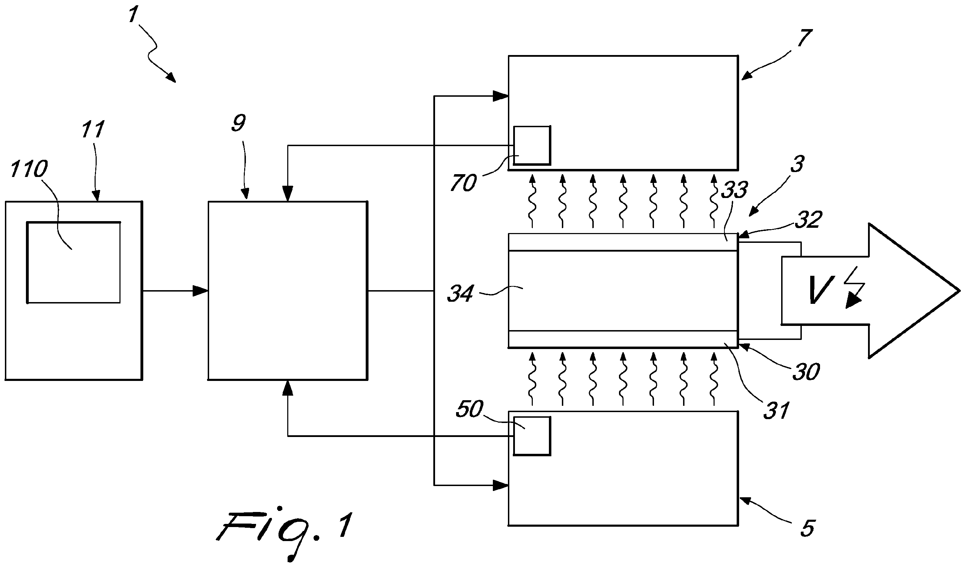

Figure 1 is a block diagram showing the main components of an embodiment of an electricity generator, according to the invention;

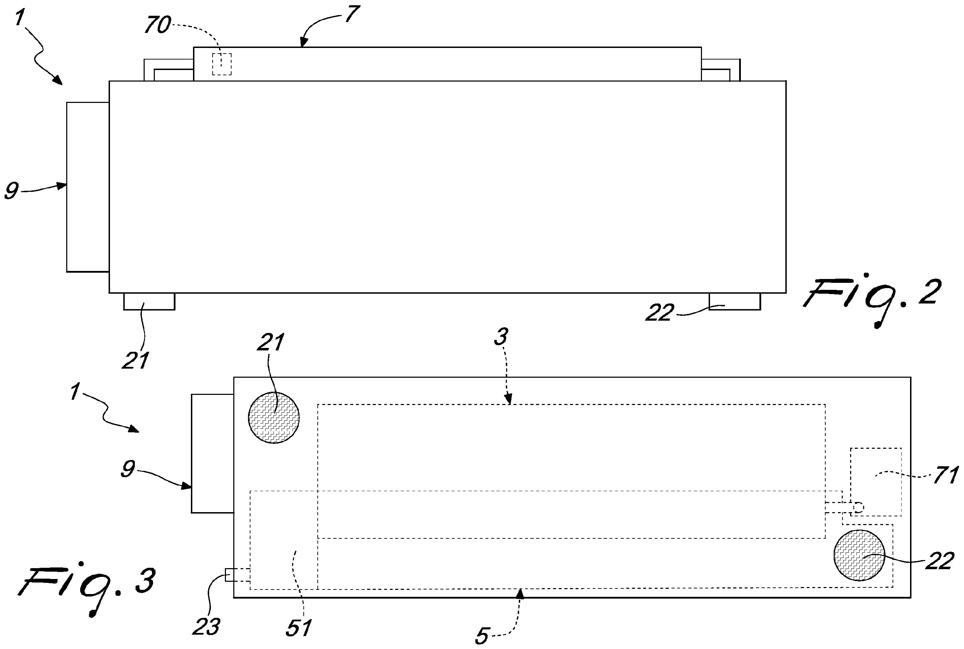

Figure 2 is a schematic view, from above, of the electricity generator, according to the invention;
Figure 3 is a schematic view, from the front, of the electricity generator in Figure 2, according to the invention;

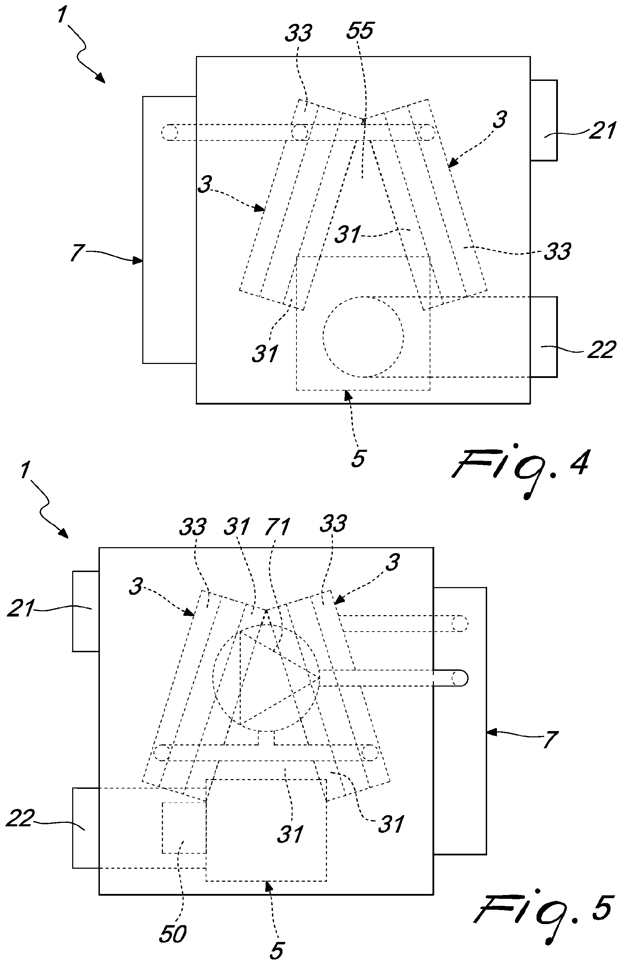

Figure 4 is a first schematic view, from the side, of the electricity generator in Figure 2, according to the invention;
Figure 5 is a second schematic view, from the side, of the electricity generator in Figure 2, according to the invention.

With reference to the figures, the electricity generator for a vehicle which comprises at least one tank of a fuel, generally designated by the reference numeral 1, comprises at least one Seebeck-effect thermoelectric generator 3 coupled to a heat source 5 and to a heat sink 7, which are adapted to generate a thermal delta across the thermoelectric generator 3 in order to generate electricity, in the form of voltage and/or electric current. The electricity generator 1 further comprises a system 9 for the management and control of the thermal delta. In particular, the management and control system 9 is adapted to manage the heat generated by the heat source 5 and the heat dissipated by the heat sink 7, so as to control and vary the aforementioned thermal delta so that the thermoelectric generator 3 generates electricity with the maximum yield.

According to the invention, the heat source 5 is supplied with the fuel present in the at least one tank of the vehicle.

The tank of the vehicle containing the fuel for supplying the heat source 5 can be the tank that contains the fuel for supplying the vehicle, i.e. the fuel necessary in order to make the vehicle move forward.

Alternatively, the tank of the vehicle containing the fuel for supplying the heat source 5 can be the tank that contains the fuel for supplying at least one of the user devices that are present on board the vehicle. For example, the fuel for supplying the heat source 5 can be the gasoline or Diesel fuel contained in the tank of the vehicle.

Obviously, it is also possible for the vehicle to be provided with both the above mentioned types of tank, and therefore the heat source 5 will be supplied by the fuel present in one of the two types of tank.

For example, if the vehicle is a camper van, the fuel for supplying the heat source 5 can be the fuel taken directly from the tank of the system required to ensure the operation of onboard user devices such as refrigerators, stoves and systems for heating the vehicle. In particular, such fuel can be gas, or even pellets.

The Seebeck-effect thermoelectric generator 3 comprises a first terminal 30, which comprises a first flat element 31, and a second terminal 32, which comprises a second flat element 33. Between the first flat element 31 and the second flat element 33 there is a layer of semiconductor material 34. Advantageously, the heat source 5 faces the first flat element 31, in order to heat it, while the heat sink 7 faces, or is connected to, the second flat element 33 in order to cool it.

When the thermoelectric generator 3 is in operation, i.e. there is a thermal delta across it, electrical energy is generated at the ends of the terminals 30 and 32, in the form of voltage and/or current.

The heat source 5 comprises a burner that is adapted to produce heat from the combustion of the fuel that is conveyed, by way of adapted supply means, from one of the tanks of the vehicle, directly to the heat source 5.

The supply of fuel can be selected from the group constituted by gas, Diesel fuel, gasoline, propane gas, LPG, methane and pellets.

Advantageously, the electricity generator 1 can comprise a remote control system 11, for example wireless, for interfacing with the management and control system 9. In particular the user, by way of for example the display 110 of the remote control system 11, can set the operating parameters of the electricity generator 1 and display the information of interest. The remote control system 11 can also be a cellular telephone, a tablet computer or a computer.

Advantageously, both the heat source 5 and the heat sink 7 each comprise a temperature sensor, indicated respectively with the reference numerals 50 and 70, which are connected to the management and control system 9. In particular, based on the temperature information received from the temperature sensors 50 and 70, the management and control system 9 is capable of managing the operation of the heat source 5 and of the heat sink 7, ensuring the correct delivery of current by the thermoelectric generator 3.

Advantageously, the heat source 5 can comprise a dedicated control system 51, which is connected to the management and control system 9.

The heat sink 7 comprises a liquid cooling system, which is integrated in the thermoelectric generator 3 and comprises a pump 71. Advantageously, the heat sink 7 is adapted to maintain an operating temperature of the second flat element 33 of around 30°C. The heat sink 7 can advantageously comprise a cooling coil which is integrated in the terminal 32.

Advantageously the heat sink 7 comprises a heat absorption system, which comprises a forced ventilation system.

As illustrated in the figures, the electricity generator 1 comprises a duct 23 for supplying the fuel, which brings the fuel from one of the tanks of the vehicle to the heat source 5.

Furthermore, the electricity generator 1 comprises ducts 21, 22 for the passage of the air that circulates in the electricity generator 1.

In the embodiment of the electricity generator 1, shown in the figures, the electricity generator 1 comprises two thermoelectric generators 3, which are arranged inclined with respect to each other, so that both present the first flat element 31 to the heat source 5. Advantageously, the first flat elements 31 and the heat source 5 define an interspace 55, which has a triangular transverse cross-section. In the interspace 55 the heat generated by the heat source 5 is advantageously kept homogeneous, so as to equally heat the entire surface of both first flat elements of the two thermoelectric generators 3.

According to the power levels required, the electricity generator 1 can comprise one or more thermoelectric generators 3, conveniently arranged and conveniently dimensioned. The electricity generator 1 can further comprise a plurality of modular thermoelectric generators 3 arranged and combined according to desired geometries.

Operation of the electricity generator for a vehicle run on fuel is clear and evident from the foregoing description.

Activation of the heat source 5 and of the heat sink 7 generates a thermal delta across the Seebeck-effect thermoelectric generator 3, and this determines, at the terminals 30 and 32 of the thermoelectric generator 3, the generation of electric power which can be used to charge the battery of a vehicle, or to run the electrical devices present on the vehicle.

The heat source 5 is supplied by fuel originating directly from the vehicle, and more specifically from the tank containing the fuel for supplying the vehicle, and/or from other tanks containing fuels to supply the user devices on board the vehicle.

In practice it has been found that the electricity generator for a vehicle run on fuel, according to the present invention, achieves the intended aim and objects in that it makes it possible to produce electric power from the fuel that is already present on the vehicle, even when the vehicle is stationary and the engine of the vehicle is switched off.

In this manner it is possible to, for example, produce electric power in order to light the living compartment of a camper van during stops at night, when the camper van is stationary and the engine of the camper van is switched off.

Another advantage of the electricity generator, according to the invention, consists in that it produces electric power, on vehicles, in absolute silence and with a reduced environmental impact.

Another advantage of the electricity generator, according to the invention, consists in that it is possible to vary the operating temperature so as to ensure the maximum yield.

Another advantage of the electricity generator, according to the invention, consists in that its operation can be controlled and managed remotely.

Another advantage consists in that the electricity generator according to the invention has low running costs and simplicity of sourcing and storing of the fuel necessary to supply the heat source. In this manner the problems associated with the presence of hazardous fuels in the event of an accident are also eliminated.

The electricity generator for a vehicle run on fuel thus conceived is susceptible of numerous modifications and variations all of which are within the scope of the appended claims.

In practice the materials employed, provided they are compatible with the specific use, and the contingent dimensions and shapes, may be any according to requirements.

## Claims

1. An electricity generator (1) for a vehicle comprising at least one tank adapted to contain a fuel, which comprises at least one Seebeck-effect thermoelectric generator (3) coupled to a heat source (5) and to a heat sink (7) which are adapted to generate a thermal delta across said thermoelectric generator (3) in order to generate electricity, and which comprises a system (9) for the control and management of said thermal delta which is adapted to manage heat generation and heat dissipation, said heat source (5) comprising a burner that is supplied with said fuel of said at least one tank of said vehicle, said heat source (5) being operative independently of the operation of the engine of the vehicle, **characterized in that** said heat sink (7) comprises a liquid cooling system that is integrated in said thermoelectric generator (3), said heat source (5) and said heat sink (7) each comprising a temperature sensor (50, 70), which is connected to said management and control system (9), said management and control system being able, based on the temperature information received from said temperature sensors (50, 70), to manage the operation of the heat source (5) and of the heat sink (7), said heat sink (7) further comprising a forced ventilation system.

2. The electricity generator (1) according to claim 1, **characterized in that** it comprises a remote control system (11) for interfacing with said management and control system (9).

3. The electricity generator (1) according to one or more of the preceding claims, **characterized in that** said fuel is selected from the group constituted by gas, Diesel fuel, gasoline, propane gas, LPG, methane and pellets.

4. A vehicle, comprising an electricity generator (1) according to one or more of the preceding claims.

5. The vehicle according to claim 5, **characterized in that** said at least one tank contains the fuel for supplying said vehicle.

6. The vehicle according to claim 4, **characterized in that** said at least one tank contains the fuel for supplying at least one of user devices that are present on board said vehicle.

## Patentansprüche

1. Ein Stromgenerator (1) für ein Fahrzeug, das mindestens einen Tank umfasst, der ausgebildet ist, um einen Kraftstoff zu enthalten; mindestens einen thermoelektrischen Generator (3) mit Seebeck-Effekt umfassend, gekoppelt mit einer Wärmequelle (5) und mit einer Wärmesenke (7), die ausgebildet sind, um ein Wärmedelta in dem thermoelektrischen Generator (3) zu erzeugen, um Strom zu erzeugen; und ein System (9) zur Steuerung und Verwaltung des Wärmedeltas umfassend, das ausgebildet ist, um die Wärmeerzeugung und Wärmeabstrahlung zu handhaben; wobei die Wärmequelle (5) einen Brenner umfasst, der mit dem Kraftstoff des mindestens einen Tanks des Fahrzeugs versorgt wird; wobei die Wärmequelle (5) unabhängig vom Betrieb des Fahrzeugmotors arbeitet; **dadurch gekennzeichnet, dass** die Wärmesenke (7) ein Flüssigkeitskühlsystem umfasst, das in den thermoelektrischen Generator (3) integriert ist; wobei sowohl die Wärmequelle (5) als auch die Wärmesenke (7) einen Temperatursensor (50, 70) umfassen, der mit dem Steuerungs- und Verwaltungssystem (9) verbunden ist, wobei das Steuerungs- und Verwaltungssystem in der Lage ist, anhand der von den Temperatursensoren (50, 70) empfangenen Temperaturinformationen den Betrieb der Wärmequelle (5) und der Wärmesenke (7) zu verwalten; wobei die Wärmesenke (7) weiter ein Zwangslüftungssystem umfasst.

2. Der Stromgenerator (1) gemäß Anspruch 1, **dadurch gekennzeichnet, dass** er ein Fernsteuerungssystem (11) zur Verbindung mit dem Steuerungs- und Verwaltungssystem (9) umfasst.

3. Der Stromgenerator (1) gemäß einem oder mehreren der obigen Ansprüche, **dadurch gekennzeichnet, dass** der Kraftstoff gewählt ist aus der Gruppe bestehend aus Gas, Dieselkraftstoff, Benzin, Propangas, Flüssiggas, Methan und Pellets.

4. Ein Fahrzeug, das einen Stromgenerator (1) gemäß einem oder mehreren der obigen Ansprüche umfasst.

5. Das Fahrzeug gemäß Anspruch 5, **dadurch gekennzeichnet, dass** der mindestens eine Tank den Kraftstoff zur Versorgung des Fahrzeugs enthält.

6. Das Fahrzeug gemäß Anspruch 4, **dadurch gekennzeichnet, dass** der mindestens eine Tank den Kraftstoff zur Versorgung mindestens eines der Anwendergeräte enthält, die sich an Bord des Fahrzeugs befinden.

## Revendications

1. Générateur d'électricité (1) pour véhicule comprenant au moins un réservoir adapté pour contenir un carburant, qui comprend au moins un générateur thermoélectrique à effet Seebeck (3) couplé à une source de chaleur (5) et à un dissipateur thermique (7) qui sont adaptés pour générer un delta thermique aux bornes dudit générateur thermoélectrique (3) afin de produire de l'électricité, et qui comprend un système (9) pour la commande et la gestion dudit delta thermique qui est adapté pour gérer la génération de chaleur et la dissipation de chaleur, ladite source de chaleur (5) comprenant un brûleur qui est alimenté avec ledit carburant dudit au moins un réservoir dudit véhicule, ladite source de chaleur (5) étant fonctionnelle indépendamment du fonctionnement du moteur du véhicule, **caractérisé en ce que** ledit dissipateur thermique (7) comprend un système de refroidissement liquide qui est intégré audit générateur thermoélectrique (3), ladite source de chaleur (5) et ledit dissipateur thermique (7) comprenant chacun un capteur de température (50, 70), qui est relié audit système de gestion et de commande (9), ledit système de gestion et de commande étant apte, en se basant sur les informations de température fournies par lesdits capteurs de température (50, 70), à gérer le fonctionnement de la source de chaleur (5) et du dissipateur thermique (7), ledit dissipateur thermique (7) comprenant en outre un système de ventilation forcée.

2. Générateur d'électricité (1) selon la revendication 1, **caractérisé en ce qu'**il comprend un système de commande à distance (11) pour réaliser l'interface avec ledit système de gestion et de commande (9).

3. Générateur d'électricité (1) selon l'une ou plusieurs des revendications précédentes, **caractérisé en ce que** ledit carburant est choisi dans le groupe comprenant le gaz, le gazole, l'essence, le gaz propane, le GPL, le méthane et les granulés.

4. Véhicule comprenant un générateur d'électricité (1) selon l'une ou plusieurs des revendications précédentes.

5. Véhicule selon la revendication 5, **caractérisé en ce que** ledit au moins un réservoir contient le carburant destiné à alimenter ledit véhicule.

6. Véhicule selon la revendication 4, **caractérisé en ce que** ledit au moins un réservoir contient le carburant destiné à alimenter au moins un des dispositifs d'utilisateur qui sont présents à bord dudit véhicule.
